# EUROPEAN PATENT APPLICATION

(11) **EP 1 643 818 A1**
(43) Date of publication of application: **05.04.2006**
(21) Application number: 03817348.0
(22) Date of filing: 03.07.2003
(51) Int. Cl.: H05K 3/28

(54) **MODULE AND METHOD FOR FABRICATING THE SAME**

(71) Applicant: Hitachi, Ltd., Tokyo 100-8280 (JP); Hitachi Car Engineering Co., Ltd., Hitachinaka-shi, Ibaraki 312-0062 (JP)
(72) Inventor: EGUCHI, Syuuji c/o Hitachi, Ltd.,Intel.Prop.Group, Chiyoda-ku, Tokyo 100-8220 (JP); ASANO, Masahiko c/o Hitachi Car Engineering Co.Ltd, Hitachinaka-shi, Ibaraki 312-0062 (JP); SASAKI, Masahiro, Hitachi Car Engineering Co., Ltd, Hitachinaka-shi, Ibaraki 312-0062 (JP); UCHIYAMA, Kaoru, c/o Hitachi, Ltd.,Int. Prop.Group, Chiyoda-ku, Tokyo 100-8220 (JP)
(74) Representative: Beetz & Partner
(86) International application number: PCT/JP2003/008476
(87) International publication number: WO 2005/004563

(57) **Abstract**

A module having a smaller size with enhanced reliability and productivity, and a method for fabricating the module. The module comprises a connector (6) having metal terminals for connection, and a circuit board (1) mounting electronic components. The connector (6) and the board (1) are connected to each other through metal leads (7). The surface of the connector (6) on the side being connected to the board, the metal leads 7, and the electronic components are sealed with the same thermosetting resin (9). The thermosetting resin (9) is in solid state at temperatures of 40°C or below before curing, and the thickness of the thermosetting resin (9) sealing the electronic components is changed depending on the heights of the electronic components.

## Description

### Technical Field

The present invention relates to a module containing electronic components mounted on a board and sealed with a resin, and a method for fabricating the module. More particularly, the present invention relates to a module suitable for use as various control units and sensor modules in an automobile, and a method for fabricating the module.

### Background Art

Hitherto, various control units (e.g., an engine control unit, a motor control unit, and an automatic transmission control unit) in an automobile have been disposed in a compartment or an engine room. Those control units are generally structured such that electronic components are mounted on a printed board, and the printed board is fixed to a metal base and covered with a cover case.

Recently, a control unit directly mounted on an intake manifold or the like, i.e., an on-engine type control unit, has been proposed. A control unit using a printed board is resistant against temperatures up to about 120°C and cannot be applied as the on-engine type. A control unit using a ceramic board has higher heat resistance and can be applied as the on-engine type, but it is rather expensive. Further, the on-engine type control unit is required to have not only higher heat resistance, but also higher vibration resistance and more nearly perfect air- and water-tightness than the control unit mounted in the compartment and the engine room. Moreover, those requirements are similarly applied to sensor modules (e.g., a pressure sensor module and an air flowmeter module) in addition to the on-engine type control unit.

In order to satisfy those requirements, as one known module using a printed board and being applicable as the on-engine type, JP-A-2001-288333 discloses one example in which external lead terminals and a board are integrally molded with transfer molding. Also, JP-A-7-22722 discloses another example in which a connector and a board are integrally molded with a low-pressure (depressurized) molding process of curing a paste-like resin under heating.

Meanwhile, various control units and sensor modules for use in an automobile are required to include a CPU microcomputer of a high-speed and multi-bit processing system adapted for higher functions and higher performance. In match with such a trend, a microcomputer is packaged in the form of a multi-pin ball grid array (BGA) or chip scale package (CSP) that is small-sized and thin. Applications of the BGA and the CSP to semiconductor chips other than microcomputers are increased from the viewpoint of realizing higher-density mounting. In particular, the CSP capable of being packaged at a wafer level is expected to provide an effect of cost reduction and to be employed in a wider range of fields in future.

As known methods for mounting various electronic components including the BGA and the CSP, JP,A 2002-368183 discloses one example in which a board electrically connected to connector leads is resin-sealed in a mold held under a vacuum state by transfer molding.

### Disclosure of the Invention

However, the module disclosed in JP-A-2001-288333 has problems as follows. Because the external lead terminals are in the same position as the resin sealed surface of electronic components, a mold used in the transfer molding is required to have a structure not interfering with the external lead terminals. Resin burrs tend to occur through gaps between the lead terminals and the mold during the molding. These drawbacks give rise to a difficulty in handling and reduce productivity.

Also, the module disclosed in JP-A-7-22722 has problems that a special mold structure and apparatus are required to hold the vacuum state, and that the use of the paste-like resin as a protective resin requires a curing time of several tens minutes and prolongs a time until a product is taken out of a mold. Another problem is that, because the protective resin having the thermal expansion coefficient matched with those of an electronic circuit board and electronic components has a very high viscosity in a state of the paste-like resin before curing, a high vacuum is required to pour the resin, and hence productivity is reduced.

Further, the module disclosed in JP-A-2002-368183 has problems as follows. Because terminals for connection to the exterior are in the form of leads, the module size is increased when it has a larger number of terminals. Such a tendency to increase the module size is particularly noticeable in modules for use in automobiles and ships for the reasons that the leads are required to have a larger width and thickness from the viewpoint of connection to a connector on the connection receiving side, and that the known transfer molding has a difficulty in connecting the external terminal leads in parallel.

In addition, with the above-described three known techniques, the height of a sealing resin layer is constant with respect to the board. Therefore, when a tall component, such as an aluminum electrolytic capacitor, is used, the actual sealing resin layer has a very large thickness, i.e., 10 mm or more. This may cause not only large warpage in the electronic equipment and module, but also stresses in the electronic components. Particularly, problems may arise in causing crack rupture and peeling-off in the electronic equipment and module during mounting, and deteriorating reliability in a temperature cycle test, a thermal shock test, etc.

An object of the present invention is to provide a module having a smaller size with enhanced reliability and productivity, and a method for fabricating the module.

To achieve the above object, the present invention provides a module comprising a connector having metal terminals for connection, and a circuit board mounting electronic components, the connector and the board being connected to each other through metal leads, wherein (A) the surface of the connector on the side being connected to the board, the metal leads, and the electronic components are sealed with the same thermosetting resin, (B) the thermosetting resin is in solid state at temperatures of 40°C or below before curing, and (C) the thickness of the thermosetting resin sealing the electronic components is changed depending on the heights of the electronic components. With those features, the module can be obtained in smaller size with enhanced reliability and productivity.

Also, to achieve the above object, the present invention provides a module comprising a connector having metal terminals for connection, and a circuit board mounting electronic components, the connector and the board being connected to each other through metal leads, wherein (A) the surface of the connector on the side being connected to the board, the metal leads, and the electronic components are sealed with the same thermosetting resin, (B) the thermosetting resin is in solid state at temperatures of 40°C or below before curing, (C) the thickness of the thermosetting resin sealing the electronic components is changed depending on the heights of the electronic components, and (D) the connector is disposed perpendicularly to a surface of the board being covered with the thermosetting resin sealing the electronic components or disposed on a surface of the board on the side opposite to the surface covered with the thermosetting resin. With those features, the module can be obtained in smaller size with enhanced reliability and productivity.

Further, to achieve the above object, the present invention provides a method for fabricating a module in which a connector having metal terminals for connection, a circuit board mounting electronic components including a BGA or a CSP, and metal leads connecting the connector and the board to each other are molded with a resin, the method comprising the steps of preparing one of a low-pressure transfer molding machine and a compression molding machine with molding pressure of 5 - 70 kg/cm² and molding temperature of 150 - 180°C, or an injection molding machine with molding pressure of 20 - 100 kg/cm² and molding temperature of 150 - 180°C; preparing the thermosetting resin that is in solid state at temperatures of 40°C or below before curing; sealing the surface of the connector on the side being connected to the board, the metal leads, and the electronic components with the same thermosetting resin by using one of the molding machines; and changing the thickness of the thermosetting resin sealing the electronic components depending on the heights of the electronic components in the sealing step. With that method, the module can be fabricated in smaller size with enhanced reliability and productivity.

### Brief Description of the Drawings

Figs. 1A-1E illustrate successive steps of a method for fabricating a module according to a first embodiment of the present invention.
Figs. 2A-2G illustrate successive steps of a method for fabricating a module according to a second embodiment of the present invention.
Figs. 3A-3F illustrate successive steps of a method for fabricating a module according to a third embodiment of the present invention.
Figs. 4A-4F illustrate successive steps of a method for fabricating a module according to a fourth embodiment of the present invention.
Figs. 5A-5F illustrate successive steps of a method for fabricating a module according to a fifth embodiment of the present invention.
Figs. 6A-6H illustrate successive steps of a method for fabricating a module according to a sixth embodiment of the present invention.
Figs. 7A-7F illustrate successive steps of a method for fabricating a module according to a seventh embodiment of the present invention.
Figs. 8A-8F illustrate successive steps of a method for fabricating a module according to an eighth embodiment of the present invention.

### Best Mode for Carrying Out the Invention

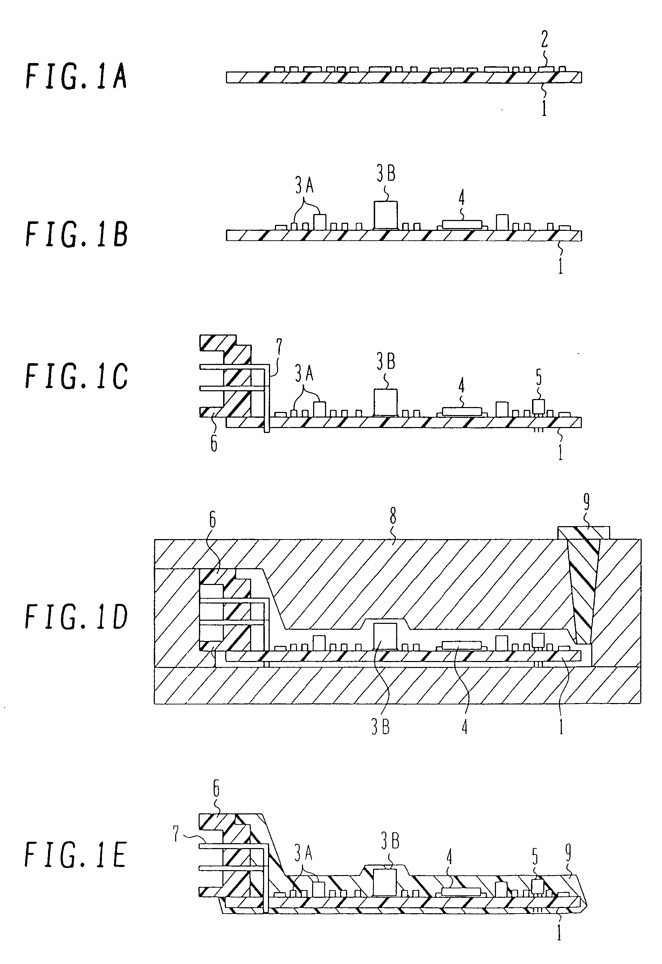

The construction of a module and a method for fabricating the module, according to a first embodiment of the present invention, will be first described below with reference to Figs. 1A-1E. The module of this embodiment is used as a control unit for automobiles, ships and motors, and a circuit board is formed of a two-layered resin printed board.

Figs. 1A-1E illustrate successive steps of the method for fabricating the module according to the first embodiment of the present invention.

As shown in Fig. 1A, an Sn/Pb eutectic-crystal solder paste 2 is printed on one surface of a two-layered resin printed board 1. The resin printed board 1 has dimensions of 100 × 70 mm and has physical properties represented by the glass transition temperature of 130°C and the linear expansion coefficient of 15 ppm/°C.

Then, as shown in Fig. 1B, short (low height) chip components 3A, e.g., a chip resistor and a ceramic capacitor, a tall (high height) chip component 3B, e.g., an aluminum capacitor, and a semiconductor package 4 are mounted on the board 1 by an automatic mounting machine. Thereafter, the board 1 is passed through a reflow furnace at maximum temperature of 210 - 240°C and is subjected to soldering.

Subsequently, in order to remove a flux, the board 1 is washed by a hydrocarbon solvent and is dried at a predetermined temperature for a predetermined time. If a solder flux requiring no washing is used, the washing step after mounting the electronic components can be omitted.

Then, as shown in Fig. 1C, after inserting a pin-insertion electronic component 5 and terminal leads 7 of a resin connector 6 in through holes formed in the resin board 1, the rear side of the board 1 is subjected to flow soldering, whereby joining of those members to the resin board 1 is completed. The resin connector 6 has metal terminals for connection at respective one ends thereof, and the other ends of the metal terminals serve as the metal leads 7.

Then, as shown in Fig. 1D, after placing a module, which has been fabricated through the step of Fig. 1C, in a mold 8 disposed inside a transfer molding machine and held at 165°C, the module is subjected to transfer molding for 3 minutes at molding pressure of 30 kg/cm² by using an epoxy-resin molding material 9 that is in solid state at room temperature and has physical properties of a curable substance, i.e., the linear expansion coefficient of 15 ppm/°C, the modulus of elasticity of 13 GPa, and the glass transition temperature of 155°C.

On that occasion, the height of an inner cavity of the mold 8 is changed depending on the heights of the electronic components mounted on the board 1. More specifically, the height of a region of the inner cavity corresponding to the position where the connector 6 is mounted is the same as that of the connector 6. The height of regions of the inner cavity corresponding to the positions where the short chip components 3A, e.g., the chip resistor and the ceramic capacitor, the semiconductor package 4, and the pin-insertion electronic component 5 are mounted is lower than that of the region corresponding to the connector 6. On the other hand, the height of a region of the inner cavity corresponding to the position where the tall chip component 3B, e.g., the aluminum capacitor, is mounted is higher than that of the regions containing the positions where the semiconductor package 4 and the pin-insertion electronic component 5 are mounted. Stated another way, a recess is formed in an inner surface of an upper mold at the position where the tall chip component 3B, e.g., the aluminum capacitor, is mounted.

Finally, as shown in Fig. 1E, the module sealed with the resin 9 is removed from the mold 8. Then, the module is subjected to a program writing process and an electrical conduction test, whereby the control unit according to this embodiment is obtained.

With the thus-constructed control unit according to this embodiment, since sealing of the electronic components and the circuit board, bonding to the connector, and molding of an entire structure of the control unit can be performed at the same time by using one kind of epoxy-resin molding material, a metal or resin case, a cap, a moisture-resistance coating film for the electronic components, etc. are no longer required. It is therefore possible to cut the number of parts and to reduce the number of steps.

Also, since the resin case and cap can be omitted and the sealing area can be minimized, it is possible to reduce the size and thickness of the control unit.

Further, since the epoxy-resin molding material is in solid state at room temperature, it is easy to handle and can be molded in a short time under heating and pressure by the transfer molding method, the compression molding method or the injection molding method. Accordingly, the existing inexpensive production equipment can be utilized and the working time can be greatly cut.

The epoxy-resin molding material employed in this embodiment has the same characteristics as those of the known semiconductor sealing material and exhibits low thermal expansion, low moisture absorbency, and high adhesion. Therefore, electric and electronic modules can have high reliability after the molding.

In addition, because the pressurized molding method using the mold is employed, the outer shape of a product can be freely set. Furthermore, since the thickness of the resin sealing layer is changed depending on the heights of the electronic components, warpage and stresses can be reduced, thus resulting in improved reliability.

The thus-constructed control unit of this embodiment can reduce the size and thickness in comparison with the known control unit. Also, the control unit of this embodiment has such high reliability as continuing a normal operation over 2000 cycles in a thermal shock test at - 40°C to 130°C and over 2000 hours in a high-temperature, high-humidity test at 85°C and 85%.

The features of the present invention represented by the above-described module according to this embodiment are as follows.

In the present invention, the module is fabricated by sealing it with a resin in a state where metal leads of a connector are connected to a board (e.g., a resin printed board or a flexible board) on which electronic components are mounted. The fabrication process is featured by;
1) the sealing resin is a thermosetting resin, and the electronic components mounted on the circuit board and the metal leads connected to the connector are sealed using the sealing resin such that they are covered with the sealing resin,
2) the sealing resin is in solid state at temperatures of 40°C or below before curing (in other words, a sealing resin in liquid or paste state at ordinary temperatures is not used), and
3) the thickness of the thermosetting resin sealing the electronic components is changed depending on the heights of the electronic components.

Those features will be described in more detail below. In the present invention, the epoxy-resin molding material containing inorganic fillers and being in solid state at temperatures of 40°C or below is used as the sealing resin for covering and sealing the electronic components mounted on the circuit board and the metal leads (or wires) for connection to the connector, which are disposed on the surface of the connector on the side being connected to the board. The epoxy-resin molding material can be the same as the ordinary sealing material for use in resin-sealed semiconductor devices.

The epoxy-resin molding material being in solid state is a sealing resin optimum for integral molding under heating and pressure, and is able to ensure moldability and reliability of the control unit at the same time. Also, by employing the depressurized molding method in addition to the integral molding under heating and pressure, a great effect of reducing voids in the sealing resin can be obtained and a remarkable improvement of reliability can be achieved.

Further, the epoxy-resin molding material is superior in adhesion to the resin connector made of polybutylene terephthalate, nylon, or polyphenylene sulfide. In addition, since neither disconnection nor peeling-off occurs in the connector metal leads (or wires) and the flexible board, reliability is further improved. One of the reasons why adhesion is increased resides in that the molding temperature is 150°C or more, which makes molecules at the interface between the connector resin and the epoxy resin entangled with each other, thus forming a strong adhesive interface. If the molding temperature is lower than 150°C, the resin viscosity is increased and moldability is reduced. An upper limit of the molding temperature depends on the material of a solder used for fixing the electronic components, etc. to the circuit board. When a PbSn eutectic-crystal solder is used, an upper limit of the molding temperature is preferably 180°C or below lower than the melting point (183°C) of the PbSn eutectic-crystal solder. When a Pb free solder is used, an upper limit of the molding temperature is preferably 220°C or below.

At least one of molten silica, crystalline silica, alumina, magnesium oxide, boron nitride, silicon nitride, silicon carbide, etc. can be used in the crushed or spherical form as the inorganic fillers contained in the epoxy-resin molding material.

The epoxy-resin molding material has a composition made up of an epoxy resin and a phenol resin hardener, and can be obtained as a combination of an orthocresol type epoxy resin, an epoxy resin having a biphenyl skeleton, an epoxy resin having a dicyclopentadiene skeleton, or an epoxy resin having a naphthalene skeleton, a bisphenol A-type epoxy resin or the like and a phenol novolak resin, orthocresol novolak resin, a phenol resin having a dicyclopentadiene skeleton, a phenol resin having a naphthalene skeleton or the like, each of those resins being in solid state at temperatures of 40°C or below. Further, in order to reduce stresses with a reduction of the modulus of elasticity, the epoxy-resin molding material may contain a stress reducing material, such as silicone rubber, oil or butadiene rubber.

Moreover, according to the present invention, the sealing resin for sealing the electronic components mounted on the circuit board and the metal leads (or wires), which are disposed on the surface of the connector on the side being connected to the board, or the flexible board is featured by having the following physical properties after curing:
linear expansion coefficient; 8 - 25 ppm/°C,
modulus of elasticity; 8 - 30 GPa, and
glass transition temperature; 80 - 200°C.

Those resin physical properties are decided with intent to reduce not only stresses caused by the differences in linear expansion coefficient among the electronic components, the circuit board and a metal heat sink, but also stresses imposed on joined portions of the electronic components to the circuit board by soldering, etc. Because the linear expansion coefficient of the sealing resin has to be as close as possible to those of the above-mentioned members, it is set to the range of 8 - 25 ppm/°C in the present invention. Also, since the electronic components and other various members having different linear expansion coefficients from one another are used in the electric and electronic modules of the present invention, it is preferable for each module to have a lower modulus of elasticity in addition to the above restriction of the linear expansion coefficient from the viewpoint of reducing stresses. On the other hand, in order to ensure mold release easiness after the molding, the modulus of elasticity is set to the range of 8 - 30 GPa. The glass transition temperature is preferably as low as possible from the viewpoint of reducing stresses. In practice, the preferable range of the glass transition temperature is 80 - 200°C in consideration of mold release easiness after the molding and the heat resistance of the module as well.

The control unit of the present invention is featured in that the thickness of the thermosetting resin layer sealing the various electronic components, which are mounted on the resin printed board or the printed board, is changed depending on the heights of the electronic components. This feature is greatly effective in reducing not only warpage of the unit, which is caused by overheating and cooling after the sealing, but also stresses caused by the differences in linear expansion coefficient. Stresses can be reduced, as described above, by setting the linear expansion coefficient of the thermosetting resin to be closer to that of the resin printed board or the flexible board. However, it is difficult to set the linear expansion coefficient of the thermosetting resin to be matched with those of all the connector parts and various electronic components (such as the package, the aluminum electrolytic capacitor, the resistor, and the capacitor) mounted on the board. For that reason, the thickness of the thermosetting resin layer is changed depending on the heights of the electronic components in order to further reduce the warpage and the stresses. The thickness of the thermosetting resin layer is preferably set to the range of 0.5 mm - 6.0 mm from the top of each electronic component. If the resin layer thickness is smaller than 0.5 mm, fluidity of the thermosetting resin is noticeably reduced during the molding. Conversely, if the resin layer thickness is larger than 6.0 mm, the effect of reducing the warpage and the stresses is hardly developed.

The circuit board used in the present invention can be any of a resin printed board made of an epoxy resin, a polyimide resin or a bismaleimide triazine resin added with glass fibers or inorganic fillers, and a flexible board made of polyimide or a liquid crystal polymer. Since the present invention is intended to provide the control unit adaptable for mounting in and on an engine, it is particularly desired that the glass transition temperature of the circuit board be 150°C or higher. In the case of the known board, called FR-4, in which the glass transition temperature is 120 - 130°C, when the environment in continued use of the control unit exceeds 130°C, the linear expansion coefficient of the board in the direction of thickness (Z-direction) is so abruptly increased as to cause through-hole disconnection in the board. In contrast, with the board having the glass transition temperature of 150°C or higher, it is possible to suppress changes in the linear expansion coefficient of the board and to greatly improve reliability even in the high-temperature environment of use, such as encountered with the on-engine mount.

Still another feature of the present invention is as follows. Since the thermosetting resin seals all over the surface of the circuit board, influences of oxidation are reduced even under high temperatures of 150°C or higher, and discoloration or characteristic deterioration caused by thermal deterioration or change in quality of the board and the solder resist material can be greatly suppressed. As a result, the present invention is applicable to the field of control units requiring high heat resistance.

The present invention is featured, as described above, in the structure obtained by integrally molding the connector and the various electronic components under heating and pressure. In that structure, the layout of the connector having the metal terminals for connection is featured in that the connector is disposed perpendicularly to the board surface covered with the thermosetting resin sealing the various electronic components. As described later in the following embodiments, the layout of the connector is also featured by the case where the connector is disposed on a board surface on the side opposite to the board surface covered with the thermosetting resin sealing the various electronic components. This layout is advantageous in enabling the known mold structure to be employed as a mold structure for molding the thermosetting resin in the present invention, and hence facilitating design and production.

Still another feature of the present invention resides in the structure that, after inserting the metal terminals for electrically connecting the circuit board and the connector in the through holes formed in the circuit board, the metal terminals are fixed using a solder or a conductive adhesive. This structure greatly increases versatility in such points as allowing the use of various standardized connectors which are commercially available at inexpensive costs and have a multi-pin or parallel-arrayed pin structure, and enabling connection between the metal terminals and the board to be performed in a short time using a solder or a conductive adhesive.

The integral molded structure of the connector and the electronic components according to the present invention is molded under the molding pressure in the range of 5 - 70 kg/cm² and at the molding temperature in the range of 150 - 180°C by using a low-pressure transfer molding machine or a compression molding machine. Those molding conditions are featured, for the reasons mentioned below, in that pressure and temperature are lower than those in molding conditions (170 - 180°C and 70 - 100 kg/cm²) for the known resin sealed semiconductor device. The low-pressure molding at 70 kg/cm² or below is required from the viewpoint of preventing deformation of the connector during the molding. Also, in the case of joining the electronic components and the circuit board with each other using an Sn/Pb eutectic-crystal solder, because the melting point of the Sn/Pb eutectic crystal is 183°C, the molding process requires to be performed at temperatures lower than that melting point, i.e., at 170°C or below. When a Pb free solder is used, an upper limit of the molding temperature is preferably 220°C or below. Conversely, if the molding pressure is lower than 5 kg/cm², voids occur in the resin or insufficient filling of the resin is caused. Further, if the molding temperature is lower than 150°C, the molding time of 5 minutes or longer is required because of insufficient curing of the resin, and productivity is extremely deteriorated. Taking into account those points, the above-mentioned ranges are preferable as the molding conditions. Moreover, according to the present invention, the integral molding can be performed by using the low-pressure transfer molding machine or the compression molding machine under the above-mentioned conditions while the mold is entirely held in a depressurized state.

The integral molded structure of the connector and the electronic components according to the present invention can also be molded by the injection molding method with the aid of an injection molding machine using the thermosetting resin. In this case, the molding conditions are set such that the molding pressure is in the range of 20 - 100 kg/cm² and the molding temperature is in the range of 150 - 180°C. In particular, the molding pressure is required to be lower than the conventional injection molding pressure, i.e., several hundreds to several thousands kg/cm². The injection molding method is a method suitable for molding a large-sized control unit.

Thus, according to the present invention, the epoxy-resin molding material used for integrally molding the electronic components and the connector has the same physical properties of a curable substance as those of the known sealing material used for resin-sealed semiconductor devices, and exhibits low thermal expansion, low moisture absorbency, and high adhesion, while containing less ionic impurities. Therefore, reliability of the control unit can be improved. Particularly, the material having the linear expansion coefficient close to those of the electronic components and the circuit board can be freely selected, and wapage and stresses can be reduced by changing the thickness of the resin sealing layer depending on the heights of the electronic components. As a result, the reliability can be further improved. Moreover, the epoxy-resin molding material is superior in adhesion to the resin connector and is greatly effective in improving reliability of the unit casing structure. In addition, since the electronic components, the metal leads for connection and joining, and the portions joined by the solder or the conductive adhesive are fixedly sealed with the epoxy-resin molding material, excellent vibration resistance and fatigue resistance of the joined portions in a temperature cycle test or a thermal shock test are obtained.

According to the present invention, since the epoxy-resin molding material is molded under heating and pressure by using the mold in accordance with the transfer molding method or the compression mold, productivity is increased in comparison with the case of using a liquid resin. Also, since the outer shape of the control unit is decided depending on the mold shape, a reduction in size and thickness of the module can be more easily achieved than the case of using a case material.

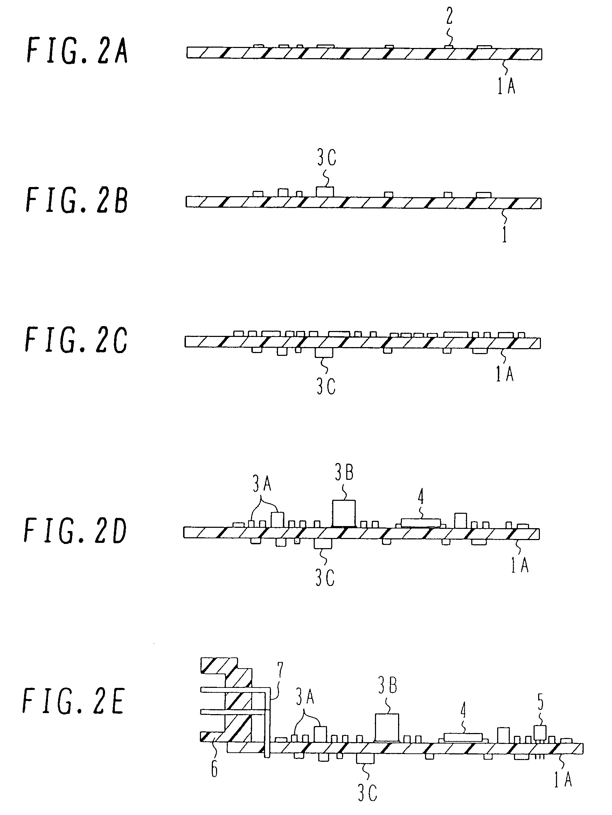

Next, the construction of a module and a method for fabricating the module, according to a second embodiment of the present invention, will be described below with reference to Figs. 2A-2G. The module of this embodiment is used as a control unit for automobiles, ships and motors, and a circuit board is formed of a four-layered resin printed board.

Figs. 2A-2G illustrate successive steps of the method for fabricating the module according to the second embodiment of the present invention. Note that the same reference numerals as those in Fig. 1 denote the same members.

As shown in Fig. 2A, an Sn/Pb eutectic-crystal solder paste 2 is printed on one surface of a four-layered resin board 1A that has dimensions of 90 × 70 mm and has physical properties represented by the glass transition temperature of 170°C and the linear expansion coefficient of 15 ppm/°C.

Then, as shown in Fig. 2B, chip components 3C, e.g., a chip resistor and a ceramic capacitor, are mounted on the circuit board 1A by an automatic mounting machine. Thereafter, the board is passed through a reflow furnace at maximum temperature of 210 - 240°C and is subjected to soldering.

Further, as shown in Fig. 2C, the circuit board 1A is turned upside down and an Sn/Pb eutectic-crystal solder paste is printed on the other surface of the circuit board 1A.

Then, as shown in Fig. 2D, chip components 3A, e.g., a chip resistor and a ceramic capacitor, a chip component 3B, e.g., an aluminum capacitor, and a semiconductor package 4 are mounted on the circuit board by the automatic mounting machine, followed by passing through the reflow furnace again for soldering.

Then, as shown in Fig. 2E, after inserting a pin-insertion electronic component 5 and terminal leads 7 of a resin connector 6 in through holes formed in the resin board 1A, the rear side of the board is subjected to flow soldering, whereby joining of those members to the resin board is completed.

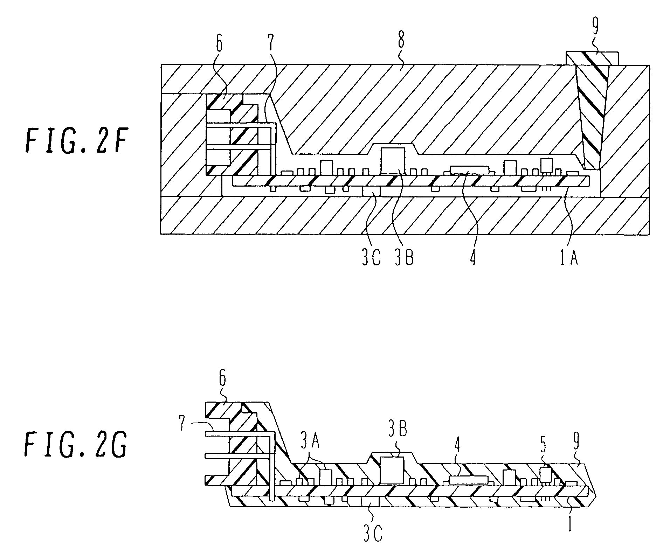

Then, as shown in Fig. 2F, after placing a unit, which has been fabricated through the step of Fig. 2E, in a mold 8 disposed inside a transfer molding machine and held at 165°C, the unit is molded for 3 minutes at molding pressure of 30 kg/cm² by using an epoxy-resin molding material 9 that is in solid state at room temperature and has physical properties of a curable substance, i.e., the linear expansion coefficient of 12 ppm/°C, the modulus of elasticity of 20 GPa, and the glass transition temperature of 125°C.

Then, as shown in Fig. 2G, the unit is removed from the mold 8. Thereafter, the unit is subjected to a program writing process and an electrical conduction test, whereby the control unit according to this embodiment is obtained.

The thus-constructed control unit of this embodiment can reduce the size and thickness in comparison with the known control unit. Also, the control unit obtained with this embodiment has such high reliability as continuing a normal operation over 1200 cycles in a thermal shock test at - 55°C to 150°C and over 2000 hours in a high-temperature, high-humidity test at 85°C and 85%. Further, since the control unit of this embodiment uses the resin printed board having the glass transition temperature of 170°C, it exhibits excellent characteristics even in a strict reliability test, i.e., a thermal shock test at - 55°C to 150°C.

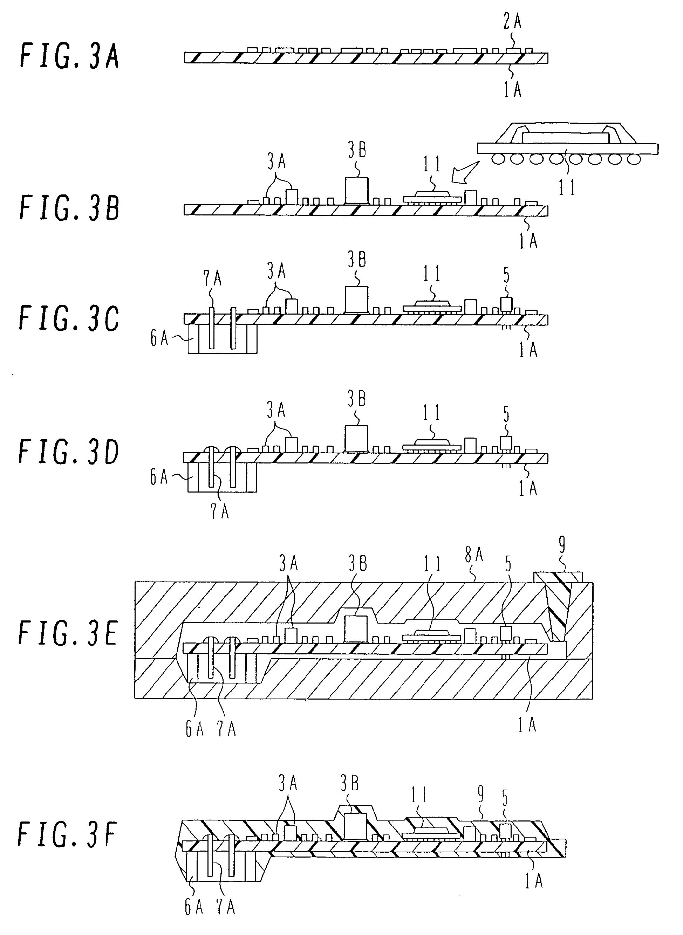

The construction of a module and a method for fabricating the module, according to a third embodiment of the present invention, will be described below with reference to Fig. 3. The module of this embodiment is used as a control unit for automobiles, ships and motors, and a circuit board is formed of a four-layered resin printed board.

Figs. 3A-3F illustrate successive steps of the method for fabricating the module according to the third embodiment of the present invention. Note that the same reference numerals as those in Figs. 1 and 2 denote the same members.

As shown in Fig. 3A, an Sn/Ag/Cu solder paste 2A is printed on one surface of a four-layered resin board 1A that has dimensions of 100 × 70 mm and has physical properties represented by the glass transition temperature of 170°C and the linear expansion coefficient of 15 ppm/°C.

Then, as shown in Fig. 3B, chip components 3A, e.g., a chip resistor and a ceramic capacitor, a chip component 3B, e.g., an aluminum capacitor, and a microcomputer BGA package 11 are mounted on the resin board 1A by an automatic mounting machine. Thereafter, the board is passed through a reflow furnace at maximum temperature of 240 - 250°C and is subjected to soldering.

Further, as shown in Fig. 3C, a pin-insertion electronic component 5 is inserted in through holes formed in the resin board 1A and is joined to the resin board by flow soldering. Thereafter, terminal leads 7A of a connector 6A are inserted in through holes formed in the resin board 1A.

Then, as shown in Fig. 3D, the terminal leads 7A of the connector 6A and the rear side of the board 1A are subjected to flow soldering, whereby joining of the terminal leads to the resin board is completed.

Then, as shown in Fig. 3E, after placing a module, which has been fabricated through the step of Fig. 3D, in a mold 8A disposed inside a transfer molding machine and held at 175°C, the module is molded for 90 seconds at molding pressure of 30 kg/cm² by using an epoxy-resin molding material 9 that is in solid state at room temperature and has physical properties of a curable substance, i.e., the linear expansion coefficient of 15 ppm/°C, the modulus of elasticity of 13 GPa, and the glass transition temperature of 155°C.

Then, as shown in Fig. 3F, the module is removed from the mold. Thereafter, the module is subjected to a program writing process and an electrical conduction test, whereby the control unit for an automobile according to this embodiment is obtained.

Additionally, this embodiment may include a process of, after the BGA package has been mounted, filling solder ball gaps under the BGA package with an underfill material. The underfill material may be an acrylic resin or an epoxy resin, which contains inorganic fillers and is in liquid state at room temperature, or such a resin containing no inorganic fillers, and may have the curing temperature in the range of 80 - 150°C. By using the underfill material, it is possible to nearly completely suppress the generation of voids in the solder ball gaps under the BGA package.

The thus-constructed control unit of this embodiment can reduce the size and thickness in comparison with the known control unit. Also, the control unit obtained with this embodiment has such high reliability as continuing a normal operation over 1200 cycles in a thermal shock test at - 55°C to 150°C and over 2000 hours in a high-temperature, high-humidity test at 85°C and 85%.

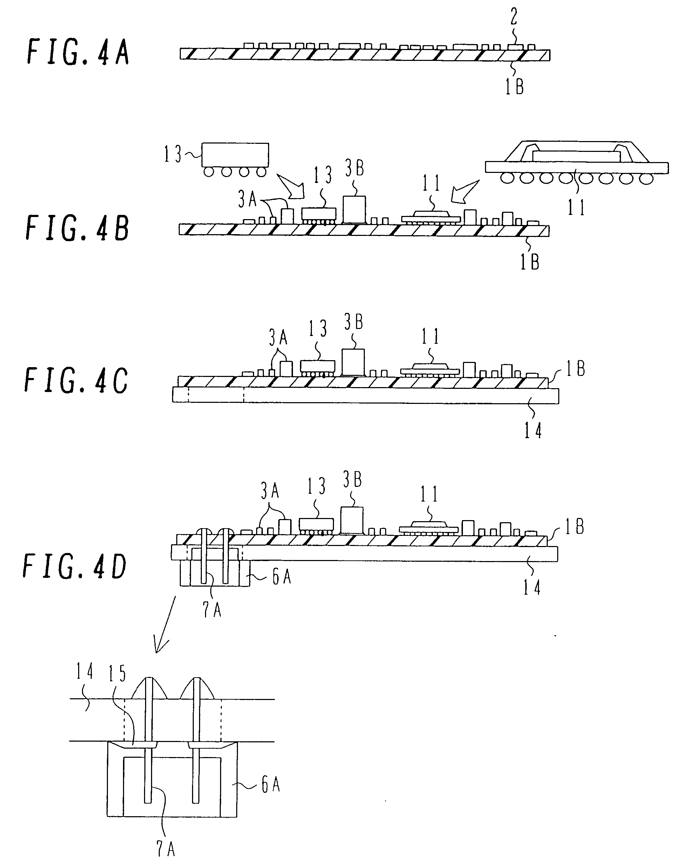

The construction of a module and a method for fabricating the module, according to a fourth embodiment of the present invention, will be described below with reference to Figs. 4A-4F. The module of this embodiment is used as a control unit for automobiles, ships and motors, and a circuit board is formed of a flexible board.

Figs. 4A-4F illustrate successive steps of the method for fabricating the module according to the fourth embodiment of the present invention. Note that the same reference numerals as those in Figs. 1 and 2 denote the same members.

As shown in Fig. 4A, an Sn/Pb eutectic-crystal solder paste 2 is printed on one surface of a two-layered flexible resin board 1B made up of polyimide with a thickness of 75 µm and a Cu wiring layer with a thickness of 35 µm on both sides, the board having dimensions of 100 × 70 mm and having physical properties represented by the glass transition temperature of 230°C and the linear expansion coefficient of 12 ppm/°C .

Then, as shown in Fig. 4B, chip components 3A, e.g., a chip resistor and a ceramic capacitor, a chip component 3B, e.g., an aluminum capacitor, a microcomputer BGA package 11, and a CSP 13 are mounted on the board 1B by the automatic mounting machine. Thereafter, the board is passed through a reflow furnace at maximum temperature of 210 - 240°C and is subjected to soldering.

Then, as shown in Fig. 4C, the flexible board 1B mounting the electronic components thereon is bonded to an aluminum base 14, which has a thickness of 3 mm and is bored in a mount area for a connector, by using an adhesive sheet with low elasticity.

Subsequently, as shown in Fig. 4D, terminal leads 7A of a connector 6A are inserted in through holes formed in the flexible board 1B and are tentatively bonded at room temperature or temperature of 150°C or below by using an adhesive primarily made of an epoxy resin or a silicone resin. Thereafter, solder joining of the terminal leads to the resin board is completed by flow soldering. The connector 6A has hollows 15 formed in its surface coming into contact with the base 14.

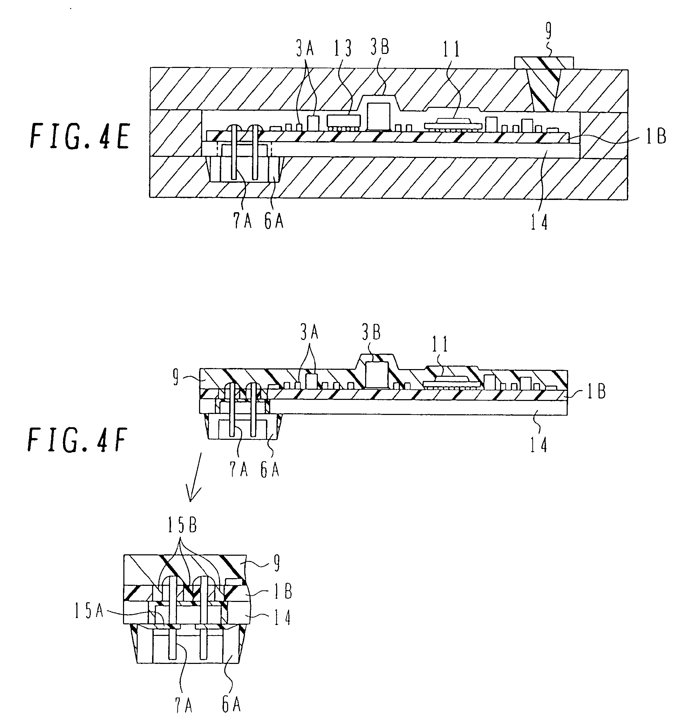

Then, as shown in Fig. 4E, after placing a module, which has been fabricated through the step of Fig. 4D, in a mold 8B disposed inside a transfer molding machine and held at 165°C, the module is molded for 3 minutes at molding pressure of 30 kg/cm² by using an epoxy-resin molding material 9 that is in solid state at room temperature and has physical properties of a curable substance, i.e., the linear expansion coefficient of 12 ppm/°C, the modulus of elasticity of 20 GPa, and the glass transition temperature of 125°C. In this connection, the flexible board 1B has through holes 15B so that the epoxy-resin molding material flows into the connector during the molding. Thus, the resin molding material flows into the hollows 15A of the connector 6A via the through holes 15B.

Then, as shown in Fig. 4F, the unit module is removed from the mold. Thereafter, the module is subjected to a program writing process and an electrical conduction test, whereby the control unit for an automobile according to this embodiment is obtained.

The thus-constructed control unit of this embodiment can reduce the size and thickness in comparison with the known control unit. Also, the control unit obtained with this embodiment has a structure that the connector is disposed on the side of the flexible board opposite to the surface on which the various electronic components are sealed with the resin. Reliability of the control board exhibits such an excellent characteristic as continuing a normal operation over 1200 cycles in a thermal shock test at - 55°C to 150°C and over 2000 hours in a high-temperature, high-humidity test at 85°C and 85%.

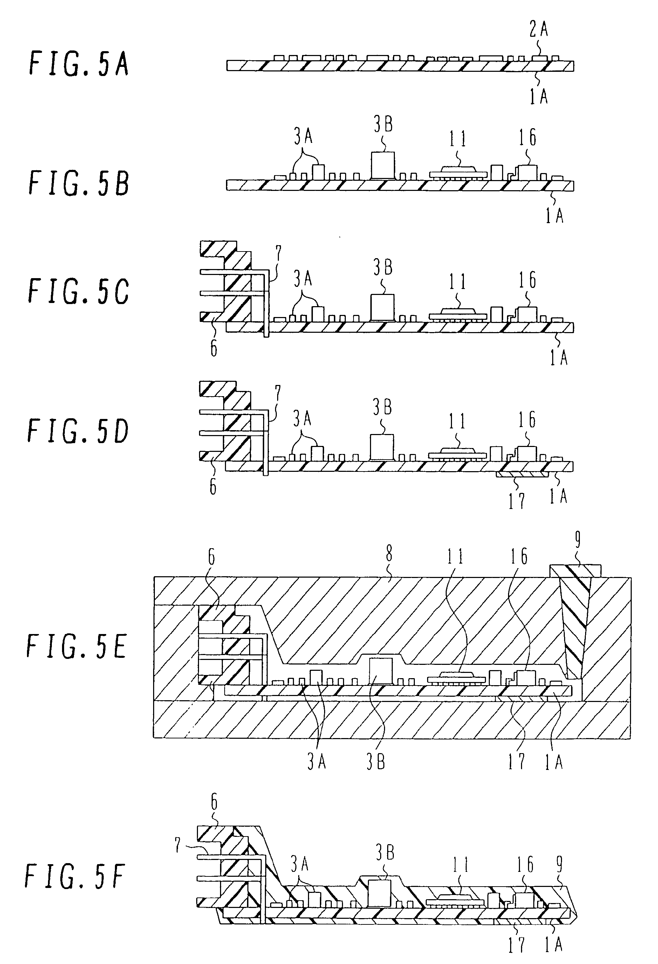

The construction of a module and a method for fabricating the module, according to a fifth embodiment of the present invention, will be described below with reference to Figs. 5A-5F. The module of this embodiment is used as a control unit for automobiles, ships and motors, and a circuit board is formed of a four-layered resin printed board.

Figs. 5A-5F illustrate successive steps of the method for fabricating the module according to the fifth embodiment of the present invention. Note that the same reference numerals as those in Figs. 1 and 2 denote the same members.

As shown in Fig. 5A, an Sn/Ag/Cu solder paste 2A is printed on one surface of a four-layered resin board 1A that has dimensions of 100 × 70 mm and has physical properties represented by the glass transition temperature of 170°C and the linear expansion coefficient of 15 ppm/°C.

Then, as shown in Fig. 5B, chip components 3A, e.g., a chip resistor and a ceramic capacitor, a chip component 3B, e.g., an aluminum capacitor, a microcomputer BGA package 11, and a power semiconductor package 16 are mounted on the resin board 1A by an automatic mounting machine. Thereafter, the board is passed through a reflow furnace at maximum temperature of 240 - 250°C and is subjected to soldering.

Then, as shown in Fig. 5C, terminal leads 7 of a connector 6 are inserted in through holes formed in the resin board 1A, and the rear side of the board 1A is subjected to flow soldering, whereby joining of the terminal leads to the resin board is completed.

Then, as shown in Fig. 5D, a heat-sink Cu plate 17 with a thickness of 2 mm is bonded using a sticky agent to the underside of the board 1A just below a portion where the power semiconductor package 16 is mounted. Here, the heat-sink plate may be made of a metal, such as aluminum or an iron-based metal having a Ni-plated surface. Alternatively, the heat-sink plate may be made of a plastic composite mixed with heat-conductive ceramic fillers or metallic fibers (fillers).

Then, as shown in Fig. 5E, after placing a unit, which has been fabricated through the step of Fig. 5D, in a mold 8 disposed inside a transfer molding machine and held at 175°C, the unit is molded for 90 seconds at molding pressure of 30 kg/cm² by using an epoxy-resin molding material 9 that is in solid state at room temperature and has physical properties of a curable substance, i.e., the linear expansion coefficient of 15 ppm/°C, the modulus of elasticity of 13 GPa, and the glass transition temperature of 155°C. In Fig. 5E, the mold 8 is shaped such that the height of an inner cavity at the positions where the BGA package 11 and the power semiconductor package 16 are mounted is the same as the height at the positions where the chip components 3A are disposed. However, as shown in Fig. 3, the height of the inner cavity at the positions where the BGA package 11 and the power semiconductor package 16 are mounted may be slightly larger than the height at the positions where the chip components 3A are disposed.

Then, as shown in Fig. 5F, the unit is removed from the mold 8. Thereafter, the unit is subjected to a program writing process and an electrical conduction test, whereby the control unit for an automobile according to this embodiment is obtained.

In the control unit of this embodiment, to ensure satisfactory heat radiation, the metal base or the plastic composite for the heat radiation is disposed at the position just below a portion of the printed board where the power semiconductor chip generating heat is mounted. The metal used for the heat radiation can be prepared in the form of a plate, a thin film or a foil, which is made of aluminum, iron or copper. The plastic composite can be made of a thermoplastic resin or a thermosetting resin mixed with carbon fibers or powder, or heat-conductive ceramic fillers such as alumina, silicon nitride, boron nitride and silicon carbide. Alternatively, a plastic plate or thin film lined with a metal foil or thin film is also usable. The metal base or the plastic composite for the heat radiation can be disposed just under the printed board by any of a method of bonding the metal base or the plastic composite for the heat radiation to the printed board with pressure contact at room temperature or under heating by using a sticky agent or an adhesive, and a method of merely placing just under the printed board and then integrating them during the molding.

The thus-constructed control unit of this embodiment can reduce the size and thickness in comparison with the known control unit. Also, the control unit obtained with this embodiment has the structure including the metal heat sink just under the board, and its reliability exhibits such an excellent characteristic as continuing a normal operation over 1200 cycles in a thermal shock test at - 55°C to 150°C and over 2000 hours in a high-temperature, high-humidity test at 85°C and 85%.

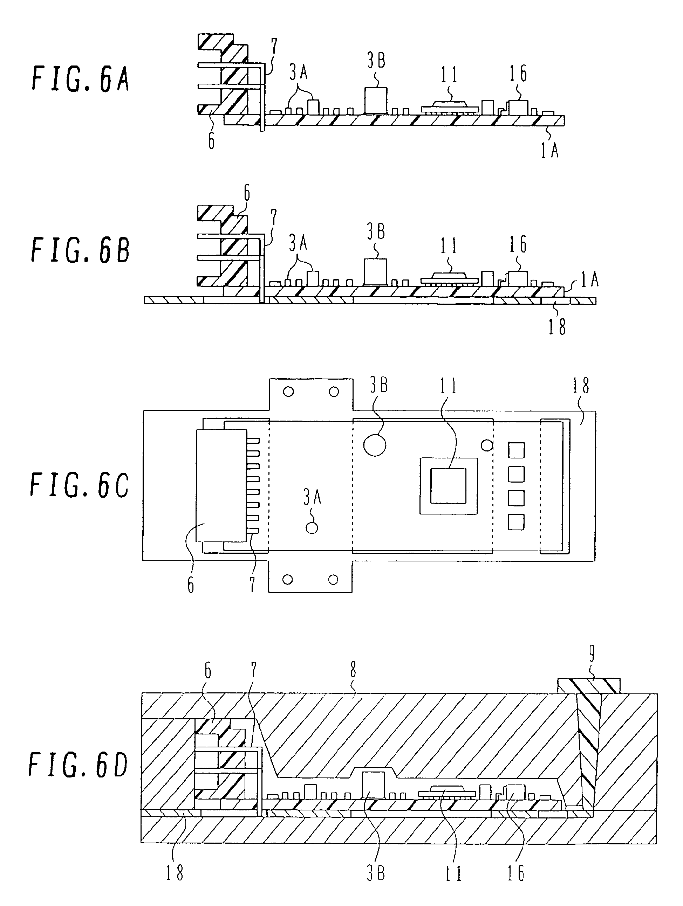

The construction of a module and a method for fabricating the module, according to a sixth embodiment of the present invention, will be described below with reference to Figs. 6A-6H. The module of this embodiment is used as a control unit for automobiles, ships and motors, and a circuit board is formed of a four-layered resin printed board.

Figs. 6A-6H illustrate successive steps of the method for fabricating the module according to the sixth embodiment of the present invention. Note that the same reference numerals as those in Figs. 1 and 2 denote the same members.

Likewise, as shown in Fig. 5A, an Sn/Ag/Cu solder paste 2A is printed on one surface of a four-layered resin board 1A that has dimensions of 100 × 70 mm and has physical properties represented by the glass transition temperature of 170°C and the linear expansion coefficient of 15 ppm/°C. Then, as shown in Fig. 5B, chip components 3A, e.g., a chip resistor and a ceramic capacitor, a chip component 3B, e.g., an aluminum capacitor, a microcomputer BGA package 11, and a power semiconductor package 16 are mounted on the resin board 1A by an automatic mounting machine. Thereafter, the board is passed through a reflow furnace at high temperature of 240 - 250°C and is subjected to soldering.

Then, as shown in Fig. 6A, terminal leads 7 of a connector 6 are inserted in through holes formed in the resin board 1A, and the rear side of the board 1A is subjected to flow soldering, whereby joining of the terminal leads to the resin board 1A is completed.

Then, as shown in Figs. 6B and 6C, a Cu-based lead frame 18 having an Sn-plated surface coating with a thickness of about 1 mm is bonded to just the underside of the resin board 1A by using an adhesive or a sticky agent primarily made of an epoxy resin, an acrylic resin or a silicone resin. Fig. 6B is a sectional view and Fig. 6C is a plan view corresponding to Fig. 6B. The Cu-based lead frame 18 serves as not only a fixture, but also a heat sink. For the purpose of the latter, the frame has a hollowed structure as shown in Fig. 6C. Also, the lead frame 18 is used as a jig for mounting the control unit in an automobile engine room or on an engine.

Then, as shown in Fig. 6D, after placing a unit, which has been fabricated through the step of Fig. 6C, in a mold 8 disposed inside a transfer molding machine and held at 175°C, the unit is molded for 90 seconds at molding pressure of 30 kg/cm² by using an epoxy-resin molding material 9 that is in solid state at room temperature and has physical properties of a curable substance, i.e., the linear expansion coefficient of 15 ppm/°C, the modulus of elasticity of 13 GPa, and the glass transition temperature of 155°C.

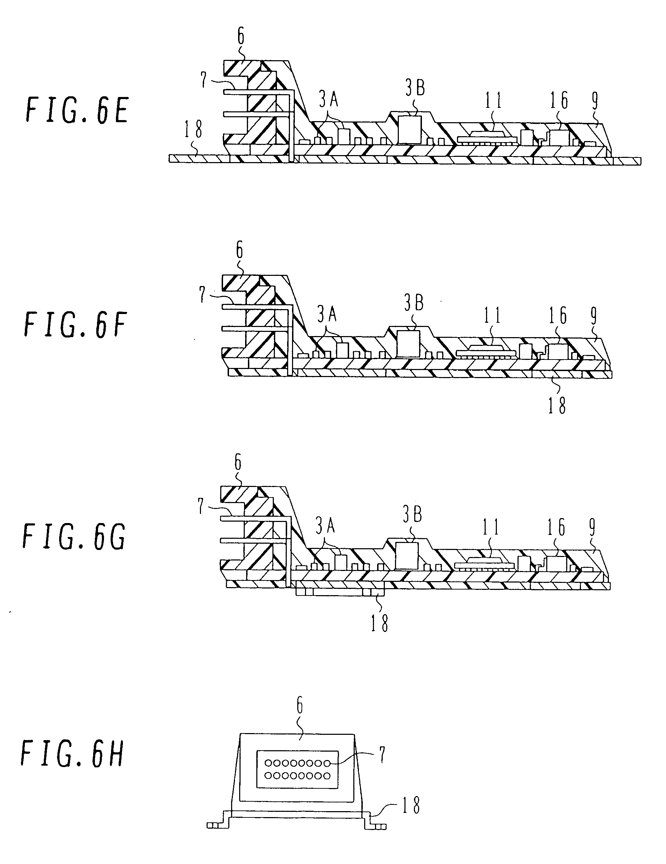

Then, as shown in Fig. 6E, the molded unit is removed from the mold 8. Thereafter, as shown in Fig. 6F, extra portions of the lead frame 18 (left and right end portions shown in Fig. 6E) are cut.

Then, as shown in Figs. 6G and 6H, the lead frame 18 is bent by trimming. Fig. 6G is a sectional view and Fig. 6H is a left side end view corresponding to Fig. 6G. The bent lead frame 18 is used as a jig for mounting the unit in the automobile engine room or the engine. Finally, the unit is subjected to a program writing process and an electrical conduction test, whereby the control unit for an automobile according to this embodiment is obtained.

This embodiment can also be practiced by a method of bonding the board to the metal lead frame in advance, then mounting the various electronic components and the connector on the board, and integrally molding them. Further, the fabrication method can be modified such that a metal frame is previously subjected to trimming to cut extra portions for attachment, and at the time of resin molding, the trimmed metal frame is placed in the mold and is molded together with the unit provided with the heat sink, shown in Fig. 5, at the same time.

The thus-constructed control unit of this embodiment can reduce the size and thickness in comparison with the known control unit. Also, the control unit obtained with this embodiment has the structure including both the heat sink and the fixture, and its reliability exhibits such an excellent characteristic as continuing a normal operation over 1200 cycles in a thermal shock test at - 55°C to 150°C and over 2000 hours in a high-temperature, high-humidity test at 85°C and 85%.

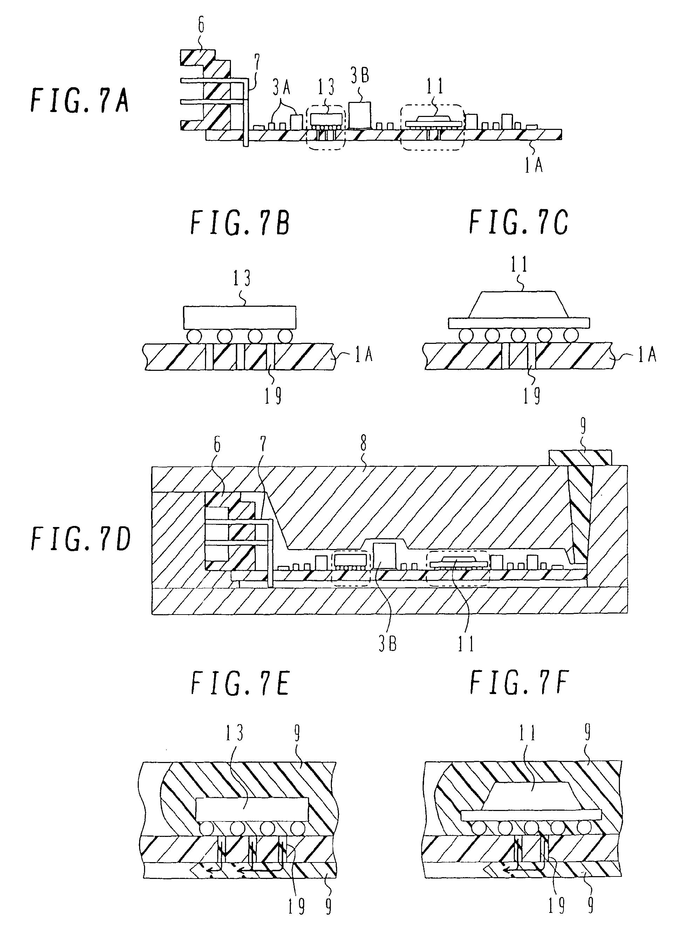

The construction of a module and a method for fabricating the module, according to a seventh embodiment of the present invention, will be described below with reference to Figs. 7A-7F. The module of this embodiment is used as a control unit for automobiles, ships and motors, and a circuit board is formed of a four-layered resin printed board.

Figs. 7A-7F illustrate successive steps of the method for fabricating the module according to the seventh embodiment of the present invention. Note that the same reference numerals as those in Figs. 1 and 2 denote the same members.

Likewise, as shown in Fig. 3A, an Sn/Ag/Cu solder paste 2A is printed on one surface of a four-layered resin board 1A that has dimensions of 100 × 70 mm and has physical properties represented by the glass transition temperature of 170°C and the linear expansion coefficient of 15 ppm/°C. Then, as shown in Fig. 3B, chip components 3A, e.g., a chip resistor and a ceramic capacitor, a chip component 3B, e.g., an aluminum capacitor, a microcomputer BGA package 11, and a CSP 13 are mounted on the board 1A by an automatic mounting machine. Thereafter, the board is passed through a reflow furnace at maximum temperature of 240 - 250°C and is subjected to soldering.

Then, as shown in Fig. 7A, terminal leads 7 of a connector 6 are inserted in through holes formed in the resin board 1A, and the rear side of the board is subjected to flow soldering, whereby joining of the terminal leads to the resin board is completed. In this embodiment, as shown in Figs. 7B and 7D in enlarged scale, Cu-plated through holes 19 each having a diameter of 300 µm are formed in portions of the printed board 1A where the BGA 11 and the CSP 13, shown in Fig. 7A, are mounted, such that the through holes 19 are positioned just under those components.

Then, as shown in Fig. 7D, after placing a unit, which has been fabricated through the step of Fig. 7A, in a mold 8 disposed inside a transfer molding machine and held at 175°C, the unit is molded for 90 seconds at molding pressure of 30 kg/cm² by using an epoxy-resin molding material 9 that is in solid state at room temperature and has physical properties of a curable substance, i.e., the linear expansion coefficient of 15 ppm/°C, the modulus of elasticity of 13 GPa, and the glass transition temperature of 155°C. At that time, because the thermosetting resin 9 becomes a low-viscosity resin in liquid state during the molding, the resin flows so as to pass the through holes 19 of the board from each of central areas of the board portions where solder balls of the BGA 11 and the CSP 13 are mounted, as shown in Figs. 7E and 7F. It is therefore possible to suppress the generation of voids in the solder ball gaps after the BGA 11 and the CSP 13 have been mounted.

Then, after removing the unit from the mold 8, the unit is finally subjected to a program writing process and an electrical conduction test, whereby the control unit for an automobile according to the present invention is obtained.

In this embodiment, the generation of voids in the solder ball gaps after mounting of the BGA and the CSP can be suppressed by a method of setting the maximum particle size of inorganic fillers contained in the epoxy-resin molding material 9 to be 50 µm or below, which is smaller than the maximum particle size of about 80 - 100 µm in the past, so that the resin is more easily filled into the solder ball gaps. This feature is effective particularly when the solder ball pitch of the BGA and the CSP is narrowed or when the solder ball diameter is reduced. With regards to the molding method, a voidless state can be achieved by performing the integral molding with a low-pressure transfer molding machine, a compression molding machine, or an injection molding machine under the above-mentioned conditions while the mold is entirely held in a depressurized state.

Thus, according to this embodiment, in the control unit mounting, as semiconductor packages, the BGA and the CSP on the board, through holes having diameters of 0.1 mm - 10 mm are bored in at least a part of the board, which corresponds to the mount area of the BGA or the CSP, so that the thermosetting resin flows via the through holes. Because the BGA and the CSP are each connected to the board with the aid of solder balls, there is a risk that the life of the solder ball connection is shortened in high-temperature, large-vibration environment of use, such as encountered when the control unit is mounted on automobiles, ships, motors, etc. In order to ensure the life of the solder ball connection, it has hitherto been general to employ a structure in which a resin called an underfill material is filled in the gaps among the solder balls, to thereby release stresses. In contrast, this embodiment employs a method of, in the step of integrally molding the connector and the various electronic components under heating and pressure, filling the gaps among the solder balls of the BGA or the CSP with the resin at the same time for the purpose of reducing the number of steps or cutting the cost. On that occasion, voids are apt to generate near a central area of the BGA or the CSP because gas cannot be sufficiently purged out of the central area during the molding. For that reason, the through holes having diameters of 0.1 mm - 10 mm are bored in at least a part of the board, which corresponds to the mount area of the BGA or the CSP, thereby forming passages through which the resin is allowed to flow during the molding.

The thus-constructed control unit of this embodiment can reduce the size and thickness in comparison with the known control unit. Also, in the control unit mounting, as semiconductor packages, the BGA and the CSP on the board, the life of the solder ball connection can be ensured by, in the step of integrally molding the connector and the various electronic components under heating and pressure, filling the gaps among the solder balls of the BGA or the CSP with the resin at the same time. Further, the control unit obtained with this embodiment has the structure including both the heat sink and the fixture, and its reliability exhibits such an excellent characteristic as continuing a normal operation over 1200 cycles in a thermal shock test at - 55°C to 150°C and over 2000 hours in a high-temperature, high-humidity test at 85°C and 85%.

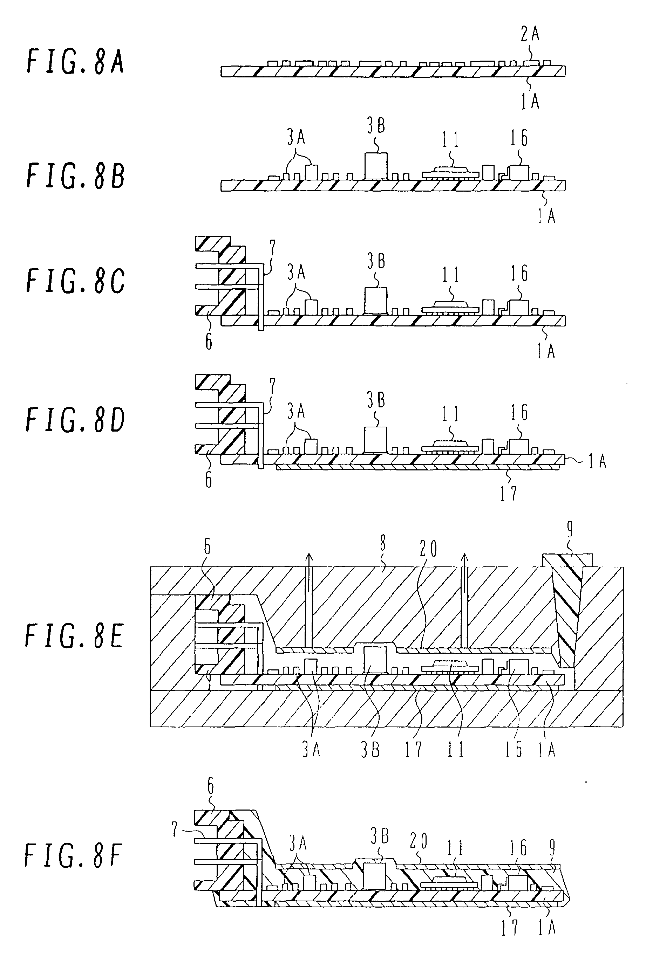

The construction of a module and a method for fabricating the module, according to an eighth embodiment of the present invention, will be described below with reference to Fig. 8. The module of this embodiment is used as a control unit for automobiles, ships and motors, and a circuit board is formed of a four-layered resin printed board.

Figs. 8A-8F illustrate successive steps of the method for fabricating the module according to the eighth embodiment of the present invention. Note that the same reference numerals as those in Figs. 1 and 2 denote the same members.

As shown in Fig. 8A, an Sn/Ag/Cu solder paste 2A is printed on one surface of a four-layered resin board 1A that has dimensions of 100 × 70 mm and has physical properties represented by the glass transition temperature of 170°C and the linear expansion coefficient of 15 ppm/°C.

Then, as shown in Fig. 8B, chip components 3A, e.g., a chip resistor and a ceramic capacitor, a chip component 3B, e.g., an aluminum capacitor, a microcomputer BGA package 11, and a power semiconductor package 16 are mounted on the resin board 1A by an automatic mounting machine. Thereafter, the board is passed through a reflow furnace at maximum temperature of 240 - 250°C and is subjected to soldering.

Then, as shown in Fig. 8C, terminal leads 7 of a connector 6 are inserted in through holes formed in the resin board 1A, and the rear side of the board 1A is subjected to flow soldering, whereby joining of the terminal leads to the resin board 1A is completed.

Then, as shown in Fig. 8D, a heat-sink Cu plate 17 with a thickness of 2 mm is bonded using a sticky agent to the underside of the board 1A just below a portion where the power semiconductor package is mounted.

Then, as shown in Fig. 8E, a unit having been fabricated through the step of Fig. 8D is placed in a mold 8 disposed inside a transfer molding machine and held at 175°C. An aluminum thin film (with a thickness of 100 µm) 20 is formed by vacuum adsorption and held on an upper inner surface of the mold 8. Subsequently, the unit is molded for 90 seconds at molding pressure of 30 kg/cm² by using an epoxy-resin molding material 9 that is in solid state at room temperature and has physical properties of a curable substance, i.e., the linear expansion coefficient of 12 ppm/°C, the modulus of elasticity of 20 GPa, and the glass transition temperature of 125°C.

Then, as shown in Fig. 8F, the unit is removed from the mold. Thereafter, the unit is subjected to a program writing process and an electrical conduction test, whereby the control unit for an automobile according to the present invention is obtained.

In the control unit of this embodiment, to ensure satisfactory heat radiation, the metal base or a plastic composite for the heat radiation is disposed, as described above, at least in the position just below a portion of the printed board where the power semiconductor chip generating heat is mounted. Further, to ensure not only heat radiation, but also electromagnetic shield, the metals or plastic composites are disposed on both opposite sides of the printed board or flexible board mounting the electronic components thereon with the electronic components and the thermosetting resin sealing the electronic components interposed between the metals or the plastic composites. This structure provides the heat radiation and the electromagnetic shield equivalent or superior to those obtained with the known structure made up of a metal base and a metal cover.

The metal used for the heat radiation and the electromagnetic shield can be prepared in the form of a plate, a thin film or a foil, which is made of aluminum, iron or copper. The plastic composite can be made of a thermoplastic resin or a thermosetting resin mixed with carbon fibers or powder, or heat-conductive ceramic fillers such as alumina, silicon nitride, boron nitride and silicon carbide. Alternatively, a plastic plate or thin film lined with a metal foil or thin film is also usable. The metal base or the plastic composite for the heat radiation can be disposed just under the printed board by any of a method of bonding the metal base or the plastic composite to the printed board with pressure contact at room temperature or under heating by using a sticky agent or an adhesive, and a method of merely placing just under the printed board and then integrating them during the molding.

The thus-constructed control unit of this embodiment can reduce the size and thickness in comparison with the known control unit. Also, since the metals or the plastic composites are disposed on both the side just under the printed board or the flexible board and the opposite side of the resin printed board (or the flexible board) mounting the electronic components thereon with the electronic components and the thermosetting resin sealing the electronic components interposed between the metals or the plastic composites, the heat radiation and the electromagnetic shield can be ensured. As a result, it is possible to greatly improve characteristics of the heat radiation and the electromagnetic shield, which have been problematic in the known plastic molded structure. Further, reliability of the control unit obtained with this embodiment exhibits such an excellent characteristic as continuing a normal operation over 1200 cycles in a thermal shock test at - 55°C to 150°C and over 2000 hours in a high-temperature, high-humidity test at 85°C and 85%.

### Industrial Applicability

According to the present invention, a module can be obtained in a smaller size with enhanced reliability and productivity.

## Claims

1. A module comprising a connector (6) having metal terminals for connection, and a circuit board (1) mounting electronic components (3A, 3B, 4), said connector and said board being connected to each other through metal leads (7), wherein:
(A) the surface of said connector (6) on the side being connected to said board, said metal leads (7), and said electronic components (3A, 3B, 4) are sealed with the same thermosetting resin (9),
(B) said thermosetting resin (9) is in solid state at temperatures of 40°C or below before curing, and
(C) the thickness of said thermosetting resin (9) sealing said electronic components is changed depending on the heights of said electronic components (3A, 3B, 4).

2. The module according to Claim 1, wherein:
said thermosetting resin is an epoxy resin that contains inorganic fillers and is in solid state at temperatures of 40°C or below.

3. The module according to Claim 1, wherein:
said thermosetting resin has the following resin physical properties after curing,
linear expansion coefficient; 8 - 25 ppm/°C,
modulus of elasticity; 8 - 30 GPa, and
glass transition temperature; 80 - 200°C.

4. The module according to Claim 1, wherein:
the glass transition temperature of said circuit board is 150°C or higher.

5. The module according to Claim 1, wherein:
ends of said metal leads are inserted in through holes formed in said board and thereafter fixed by using a solder or a conductive adhesive.

6. The module according to Claim 1, wherein:
said electronic components are electronic components including a ball grid array (BGA) (11) or a chip scale package (CSP) (13), and
a circuit board (1A) mounting said BGA or CSP has through holes (19) having diameters of 0.1 mm - 10 mm and allowing said thermosetting resin to flow via said through holes.

7. The module according to Claim 1, wherein:
said circuit board is a printed board, and
a metal base or a plastic composite (14, 17, 18) for heat radiation is disposed just under said printed board mounting a power semiconductor chip that generates heat.

8. The module according to Claim 7, wherein:
said metal base or said plastic composite for heat radiation has a smaller area than said printed board.

9. The module according to Claim 1, wherein:
a metal- or plastic-made jig for mounting said module in an automobile engine room or on an engine is disposed on a rear surface of said circuit board.

10. The module according to Claim 1, wherein:
only the electronic-component mounting surface of said circuit board is sealed with said thermosetting resin, and an opposite surface of said circuit board is fixed to or disposed on a metal or plastic casing including said connector by sticking, adhesion or a mechanical manner.

11. The module according to Claim 1, wherein:
a metal or plastic composite (20) is disposed on a surface opposite to said circuit board with said electronic components and said thermosetting resin sealing said electronic components interposed therebetween.

12. A module comprising a connector (6) having metal terminals for connection, and a circuit board (1) mounting electronic components, said connector and said board being connected to each other through metal leads (7), wherein:
(A) the surface of said connector on the side being connected to said board, said metal leads, and said electronic components are sealed with the same thermosetting resin,
(B) said thermosetting resin is in solid state at temperatures of 40°C or below before curing,
(C) the thickness of said thermosetting resin sealing said electronic components is changed depending on the heights of said electronic components, and
(D) said connector (6) is disposed perpendicularly to a surface of said board being covered with said thermosetting resin sealing said electronic components or disposed on a surface of said board on the side opposite to the surface covered with said thermosetting resin.

13. A method for fabricating a module in which a connector (6) having metal terminals for connection, a circuit board (1) mounting electronic components including a BGA or a CSP, and metal leads (7) connecting said connector and said board to each other are molded with a resin, the method comprising the steps of:
preparing one of a low-pressure transfer molding machine and a compression molding machine with molding pressure of 5 - 70 kg/cm² and molding temperature of 150 - 180°C, or an injection molding machine with molding pressure of 20 - 100 kg/cm² and molding temperature of 150 - 180°C;
preparing thermosetting resin that is in solid state at temperatures of 40°C or below before curing;
sealing the surface of said connector on the side being connected to said board, said metal leads, and said electronic components with the same thermosetting resin by using one of said molding machines; and
changing the thickness of said thermosetting resin sealing said electronic components depending on the heights of said electronic components in said sealing step.

14. The method for fabricating a module according to Claim 13, wherein:
said circuit board is fixed to or disposed on a metal or plastic casing by sticking or adhesion to which said connector is tentatively fixed in advance, and thereafter said electronic components and a connector portion are integrally molded with said thermosetting resin.
